# EUROPEAN PATENT SPECIFICATION

(11) **EP 1 546 988 B1**
(45) Date of publication and mention of the grant of the patent: **14.02.2007**
(21) Application number: 03748382.3
(22) Date of filing: 15.09.2003
(51) Int. Cl.: G06K 7/00

(54) **CONNECTOR FOR CHIP-CARD**
CHIPKARTVERBINDER
CONNECTEUR POUR CARTE A PUCE

(30) Priority: 25.09.2002 FR 0211840
(43) Date of publication of application: 29.06.2005
(73) Proprietor: Koninklijke Philips Electronics N.V., 5621 BA Eindhoven (NL)
(72) Inventor: MAUGARS, Philippe, F-75008 Paris (FR)
(74) Representative: Röggla, Harald
(86) International application number: PCT/IB2003/004069
(87) International publication number: WO 2004/029858

(56) References cited:
- US-A- 4 993 956
- US-A- 5 309 324
- US-A- 5 902 152
- US-A- 6 165 021

## Description

### FIELD OF THE INVENTION

The invention relates to a connector comprising contact pins intended to be in contact with a chip card.
The invention has many applications in the field of communications appliances for exchanging data with chip cards.

### BACKGROUND OF THE INVENTION

An electrical connector permits to electrically connect a chip card with a chip card reader. Various types of signals are exchanged between the chip card and the chip card reader via the connector. A connectors is used, for example, for chip cards in professional products, for example in the banking world or in consumer products, in portable devices such as mobile telephones. In particular, electric power signals (for example delivering the power supply) and data signals (for example binary signals conveying information read or written on the chip card) are exchanged.
Specific processing circuits are generally provided for ensuring the management of these various signals, for example, to verify their potential level. These processing circuits may directly be placed on the connector.

United States patent no. 6,165,021 describes a connector of this type in which an integrated circuit is placed on the chip card connector. This known connector has two separate areas remote from each other :
- a first area dedicated to the connection with a chip card via a set of contact pins,
- a second area for receiving an integrated circuit in charge of performing specific processings on the electric signals exchanged between the chip card and the chip card reader.

This known type of connector has a certain number of limitations. Indeed, to perform specific processings, contact pins are connected to the integrated circuit by connection tracks via the printed circuit board (PCB) of the chip card reader. These connection tracks form current loops which cause interference via the inductive effect on the electric signals exchanged between the chip card and the chip card reader. This interference is stronger as these connection tracks are more numerous and as they are longer. For such a connector, a chip card presenting a data signal that has a high impedance is particularly sensitive to such interference. This connector is not in conformity with the standards of the new chip generations having a power voltage supply which equals 1.8 V.
Moreover, the miniaturization of this connector is not very important considering these two separated areas, which renders its use difficult in highly miniaturized products such as portable telephones or Personal Digital Assistants (PDA).

United States patent no.5902152 describes a connector for a chip card. The connector is made up of a component for control of the reading-writing operations of the chip card and a reading frame for the chip card. The reading frame comprises a support component made of insulating material and receiving contact terminals of a first type projecting from an upper plane of the support made of insulating material in order to be in electrical contact with contact areas of the chip card. The insulating support comprises a lower face inscribing in a lower plane, from which, on the one hand, contact terminals of a second type project so as to be in electrical contact with contact areas of the component for control of the reading-writing operations of the chip card and, on the other hand, connection leg pieces for connection onto a printed circuit. The leg height defines a space between the insulating support and the printed circuit such that the control component is housed between the lower plane of the insulating support and the printed circuit.

This known type of connector has a further number of limitations. Indeed, having the control component housed between the lower plane of the insulating support and the printed circuit does not allow inserting or removing the control component from the connector either before or after the connector is connected to the board. In addition, the miniaturization of this connector is not satisfactory considering the fact that the control component is housed between the lower plane of the insulating support and the printed circuit, thus leaving no empty space.

### OBJECT AND SUMMARY OF THE INVENTION

It is an object of the invention to propose a connector for a chip card which does not interfere with exchanged signals and whose degree of miniaturization is high.
To this end, the connector according to the invention comprises :
- an upper surface and a lower surface,
- contact pins emerging above said upper surface and intended to be in contact with a chip card,
- contact pins emerging below said lower surface and intended to be in contact with a board,
- a cavity in said upper surface intended to receive a circuit comprising contact tabs, said cavity comprising contact surfaces connected to said contact pins and intended to be in contact with said contact tabs.

The connection tracks between the contact pins of the connector and the contact tabs of the circuit have minimum length which reduces the parasitic phenomena coming from the inductive effect.
Having a cavity in said upper surface allows inserting or removing the circuit from the connector either before or after the connector is connected to the board, which facilitates the manufacturing and the maintenance.
Moreover, this cavity is sized for completely receiving the circuit in the connector so that the miniaturization is increased.

Since the contact pins emerge below the lower surface, an empty space between the connector and the board is created. The connector can thus be placed advantageously above existing components fixed to the board, or additional components can be placed in this empty space, which allows using in a relevant manner the area below the connector, increasing the degree of miniaturization.

In an improved embodiment, the cavity is placed in a central area bounded by the contact pins.
This particular embodiment facilitates the length minimization of the connection between the contact pins of the connector and the contact tabs of the circuit, leading to a reduction of the parasitic phenomena coming from the inductive effect.

In an improved embodiment, the connector according to the invention comprises holding means for holding the circuit in the cavity.
These holding means guarantee that the circuit is reliably locked in the connector.

In an improved embodiment, the connector according to the invention comprises additional connection means for electrically connecting the contact tabs and said contact surfaces.
These additional connection means improve the electrical contact between the contact tabs of the circuit and the contact surfaces of the connector.

In an improved embodiment, the connector according to the invention comprises a circuit having decoupling capacitors electrically connected between an electrical ground and the contact tabs.
The integration of the decoupling capacitors with the circuit permits to further reduce the possible phenomena of interference and noise on the contact surfaces of the connector, considering that these decoupling capacitors are nearest to the contact pins of the connector when the circuit is inserted into the connector.

The invention also relates to a chip card reader, a mobile telephone set and a personal digital assistant comprising a connector as described earlier.

### BRIEF DESCRIPTION OF THE DRAWINGS

These and other aspects of the invention are apparent from and will be elucidated, by way of non-limitative example, with reference to the embodiment(s) described hereinafter. In the drawings:
Fig.1 depicts a connector according to the invention,
Fig.2 depicts a circuit intended to be inserted in the connector according to the invention,
Fig.3 depicts a connector according to the invention comprising an inserted circuit.

### DETAILED DESCRIPTION OF THE INVENTION

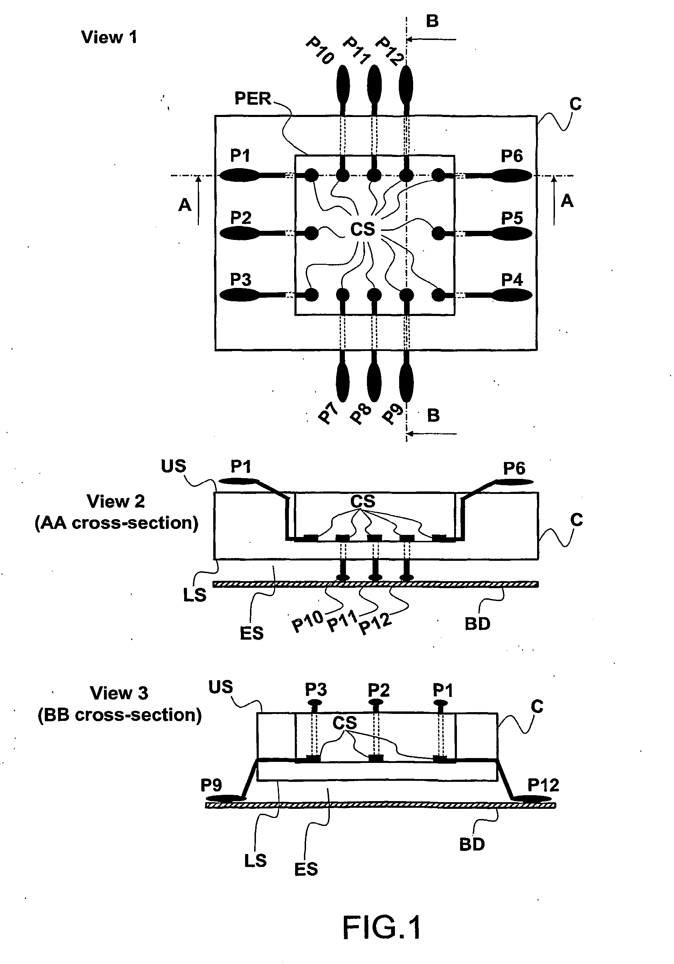

Fig.1 depicts a connector C according to the invention. The view 1 corresponds to the top view, the view 2 corresponds to the cross-sectional view along axis AA, and the view 3 corresponds to the cross-sectional view along axis BB. This connector C comprises :
- an upper surface US and a lower surface LS,
- contact pins P1-P6 emerging above said upper surface US and intended to be in contact with a chip card (not represented),
- contact pins P7-P12 emerging below said lower surface LS and intended to be in contact with a board BD,
- a cavity in said upper surface US intended to receive a circuit IC comprising contact tabs CT. The cavity comprises contact surfaces CS which are electrically connected to the contact pins P1-P12 and intended to be in contact with said contact tabs CT.

Each contact pin P1-P6 is electrically connected to a contact surface CS. For chip cards comprising 6 contacts, the connection of the pins P1-P6 is for example defined as follow:
- P1 corresponds to the supply terminal VDD of the chip card (1.8 V or 3.6 V),
- P2 corresponds to a RESET terminal for a reset-to-zero,
- P3 corresponds to the clock terminal CLK which clocks the data rate,
- P4 corresponds to the input/output terminal I/O of the data of the chip card,
- P5 terminal not used,
- P6 corresponds to a ground GND serving as a reference potential.

The cavity is preferably placed in a central area bounded by the contact pins. In Fig. 1, the cavity is delimited by the perimeter PER. The cavity is for example designed to receive an integrated circuit in the frame format referred to as MLF (MicroLead Frame).

The contact pins P7-P12 are intended to transport incoming and/or outgoing signals of the circuit without having contact with the chip card. Each contact pin P7-P12 is electrically connected to a contact surface CS.
The contact pins P7-P12 are intended to be soldered or connected to a board BD of an application (not represented) playing a role of chip card reader, such as a PCB. These contact pins P7-P12 allow creating an empty space ES between the lower surface LS and the board BD so that the connector C can be placed above existing components (not represented) being placed on the board, or additional components (not represented) can be placed in this empty space ES.

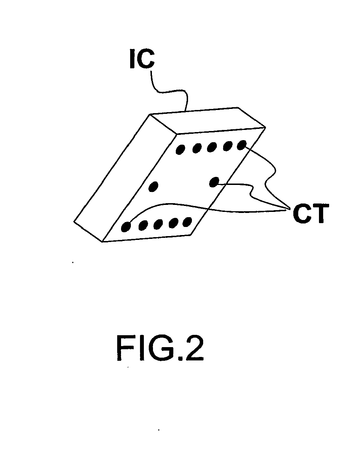

Fig.2 depicts a circuit IC intended to be inserted in the connector C according to the invention. This circuit IC is an integrated circuit comprising a plurality of contact tabs CT. This circuit corresponds advantageously to a small and thin integrated circuit, for example in the frame format MLF (Micro Lead Frame) since this format facilitates the miniaturization of the connector.
The circuit IC is in particular in charge of the electrical interface with the chip card (for example in charge of a short-circuit detection, of the conversion and regulation of supply voltage of the chip card, of the reset-to-zero, of the data exchange).
This circuit may comprises advantageously a voltage up-converter for elevating the input voltage of a periodical signal applied to one of the pins P7-P 12, in view of generating an output voltage to the chip card via the pins P1-P6. This converter may correspond to a charge pump voltage doubler.
Advantageously, the circuit IC comprises decoupling capacitors (not represented) placed between the ground GND and the contact tabs CT for attenuating the high-frequency parasitic components. The circuit being located nearest the contact pins of the connector, the effect of the decoupling capacitors is all the better.

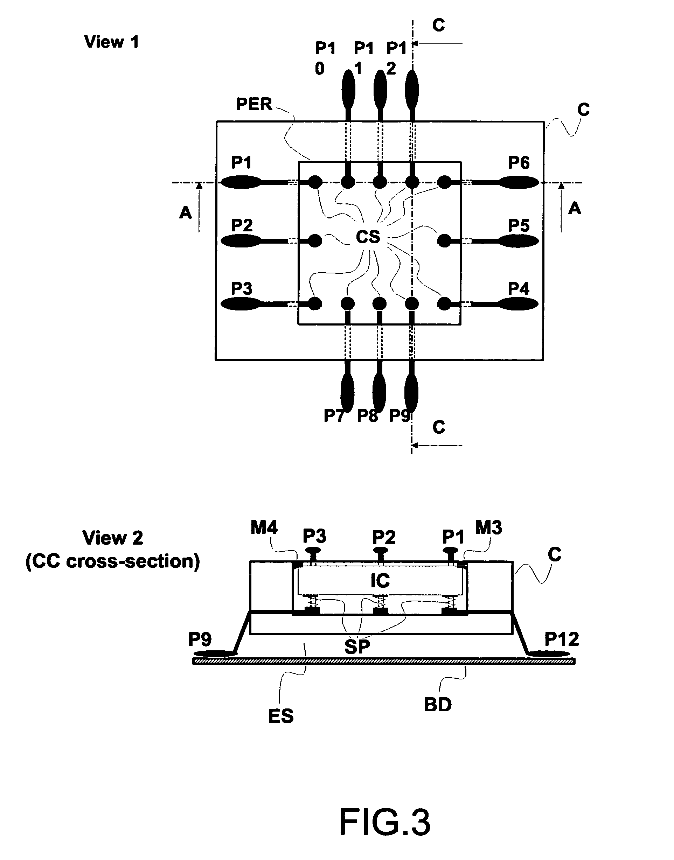

Fig.3 depicts a connector C according to the invention in which a circuit IC is inserted. The view 1 corresponds to the top view, and the view 2 corresponds to the cross-sectional view along axis CC.
As depicted, the contact tabs CT of the circuit IC are electrically connected to the contact surfaces CS either by additional connection means ensuring proper electrical contact, for example by means of springs SP, or directly (not represented)..
This connector comprises advantageously holding means M1-M4 for holding the integrated circuit IC in the cavity. These holding means may for example correspond to spring-mounted flexible tabs, said flexible tabs moving away from an initial position when the integrated circuit IC is inserted, and coming back to said initial position when the integrated circuit reaches the bottom of the cavity so as to rest against the outside surface of the integrated circuit. Of course, a limited number of holding means may also be considered (not represented).

The connector according to the invention may be used in various apparatus such as chip card readers for professional-use apparatus (e.g. bank card reader), for mobile phones or personal digital assistants (e.g. PDA, electronic diary). When a user inserts a chip card into one of these appliances, the connector according to the invention allows interfacing said chip card with the appliance.

The invention has been described based on a connector for a chip card having 6 contact pins. However, this invention can also be used with a connector for a chip card having a different number of contact pins, for example a chip card having 8 contact pins complying with the IS07816 standard, which is in particular the case for GSM-type applications. Similarly, the number of contacts pins in contact with the board may differ without departing of the scope of the invention.

## Claims

1. Connector (C) comprising :
- an upper surface (US) and a lower surface (LS),
- contact pins (P1-P6) emerging above said upper surface (US) and intended to be in contact with a chip card,
- contact pins (P7-P12) emerging below said lower surface (LS) and intended to be in contact with a board (BD),
the connector is **characterized in that** it further comprises:
- a cavity in said upper surface (US) intended to receive a circuit (IC) comprising contact tabs (CT), said cavity comprising contact surfaces (CS) connected to said contact pins and intended to be in contact with said contact tabs (CT).

2. Connector (C) as claimed in claim 1, where the connector further comprises the circuit (IC) comprising contact tabs (CT) connected to said contact pins.

3. Connector as claimed in claim 1 or 2 where the cavity is placed in a central area bounded by the contact pins.

4. Connector as claimed in claim 1, 2 or 3 comprising holding means (M1-M4) for holding the circuit (IC) in the cavity.

5. Connector as claimed in claim 1, 2, 3 or 4 comprising additional connection means (SP) for electrically connecting the contact tabs (CT) and said contact surfaces (CS).

6. Connector as claimed in claim 2, 3, 4 or 5 where the circuit (IC) comprises decoupling capacitors connected between a ground (GND) and the contact tabs (CT).

7. Chip card reader comprising a connector as claimed in claim 1 or 2.

8. Mobile telephone comprising a connector as claimed in claim 1 or 2.

9. Personal digital assistant comprising a connector as claimed in claim 1 or 2.

## Patentansprüche

1. Verbindungsstück (C), umfassend:
- eine obere Oberfläche (US) und eine untere Oberfläche (LS),
- Kontaktbeine (P1-P6), die aus der oberen Oberfläche (US) herausragen und für den Kontakt mit einer Chipkarte bestimmt sind,
- Kontaktbeine (P7-P12), die aus der unteren Oberfläche (LS) herausragen und für den Kontakt mit einer Leiterplatte (BD) bestimmt sind,
wobei das Verbindungsstück (C) **dadurch gekennzeichnet ist, dass** es weiterhin umfasst:
- eine Vertiefung in der oberen Oberfläche (US), die dafür ausgelegt ist, einen Schaltkreis (IC) aufzunehmen, der Kontaktfahnen (CT) umfasst;
wobei der Hohlraum Kontaktoberflächen (CS) umfasst, die mit den Kontaktbeinen (P1-P12) verbunden sind und dafür bestimmt sind, in Kontakt mit den Kontaktfahnen (CT) zu stehen.

2. Verbindungsstück (C), wie in Anspruch 1 beansprucht, wobei das Verbindungsstück (C) weiterhin den Schaltkreis (IC) umfasst, der Kontaktfahnen (CT) umfasst, die mit den Kontaktbeinen (P1-P12) verbunden sind.

3. Verbindungsstück (C), wie in Anspruch 1 oder 2 beansprucht, wobei die Vertiefung in einem zentralen Bereich platziert ist, der von den Kontaktbeinen (P1-P12) begrenzt wird.

4. Verbindungsstück (C), wie in Anspruch 1, 2 oder 3 beansprucht, der eine Haltevorrichtung (M1-M4) für das Halten des Schaltkreises (IC) in der Vertiefung umfasst.

5. Verbindungsstück (C), wie in Anspruch 1, 2, 3 oder 4 beansprucht, der eine zusätzliche Verbindungsvorrichtung (SP) für die elektrische Verbindung der Kontaktfahnen (CT) mit den Kontaktoberflächen (CS) umfasst.

6. Verbindungsstück (C), wie in Anspruch 2, 3, 4 oder 5 beansprucht, wobei der Schaltkreis (IC) Entkopplungskondensatoren umfasst, die zwischen einer Erdung (GND) und den Kontaktfahnen (CT) angeschlossen sind.

7. Chipkartenlesegerät, das ein Verbindungsstück (C), wie in Anspruch 1 oder 2 beansprucht, umfasst.

8. Funktelefon, das ein Verbindungsstück (C), wie in Anspruch 1 oder 2 beansprucht, umfasst.

9. Personal Digital Assistant, das ein Verbindungsstück (C), wie in Anspruch 1 oder 2 beansprucht, umfasst.

## Revendications

1. Connecteur (C) comprenant :
- une surface supérieure (US) et une surface inférieure
- des broches de contact (P1-P6) dépassant au-dessus de ladite surface supérieure (US) et destinées à venir en contact avec une carte à puce,
- des broches de contact (P7-P12) dépassent au-dessous de ladite surface inférieure (LS) et destinées à venir en contact avec une plaquette (BD),
Le connecteur est **caractérisé en ce qu'**il comprend :
- une cavité dans ladite surface supérieure (US) destinée à recevoir un circuit (IC) comprenant des languettes de contact (CT), ladite cavité comprenant des surfaces de contact (CS) connectées auxdites broches de contact et destinées à venir en contact avec lesdites languettes de contact (CT).

2. Connecteur (c) selon la revendication 1, le connecteur comprenant en outre le circuit (IC) comprenant des languettes (CT) connectées auxdites broches de contact.

3. Connecteur selon la revendication, 1 ou 2, dans lequel la cavité est placée dans une zone centrale limitée par les broches de contact.

4. Connecteur selon, la revendication 1 2 ou 3 comprenant des moyens de retenue (M1-M4) pour retenir le circuit (IC) dans la cavité,

5. Connecteur selon la revendication 1,2,3 ou 4 comprenant des moyens de connexion supplémentaires (SP) pour connecter électriquement les languettes de contact (CT) et lesdites surfaces de contact (CS),

6. Connecteur selon la revendication 2, 3, ou 5, le circuit (IC) comprenant des capaciteurs de découplage connectés entre une masse (GND) et les languettes de contact (CT).

7. Lecteur de carte à puce comprenant un connecteur tel que défini dans la revendication ou 2.

8. Téléphone mobile comprenant un connecteur tel que défini dans la revendication 1 ou 2.

9. Assistant numérique personnel comprenant un connecteur tel que défini dans la revendication 1 ou 2.
